# EUROPEAN PATENT APPLICATION

(11) **EP 4 815 313 A1**
(43) Date of publication of application: **30.09.2026**
(21) Application number: 25166236.7
(22) Date of filing: 26.03.2025
(51) Int. Cl.: H03M 1/12, H03M 3/00, H04R 3/00

(54) **MICROPHONE INPUT COUPLING CIRCUIT**

(71) Applicant: NXP B.V., 5656 AG Eindhoven (NL)
(72) Inventor: KAMRAN, Muhammad, 5656 AE Eindhoven (NL); ZHAO, Peng, 5656 AG Eindhoven (NL); KUP, Bernardus Martinus Johannes, 5656 AG Eindhoven (NL)
(74) Representative: Schwarzweller, Thomas

(57) **Abstract**

The disclosure relates to a microphone input coupling circuit (500) comprising a sigma-delta ADC (501) and a DC control loop (508) connected to receive a digital output signal (506) from the ADC and configured to provide a DC correction signal (Dcorr) to a feedback DAC (507) of the ADC (501), the DC control loop (508) comprising a low pass filter (702) configured to extract a DC offset from the digital output signal to generate the DC correction signal (Dcorr), wherein the feedback DAC (507) is configured to apply a DC offset to the feedback signal (dac_out) according to the DC correction signal (Dcorr).

## Description

### Field

The disclosure relates to a microphone input coupling circuit.

### Background

Analog to digital converters (ADCs) in microphone input circuits require an input DC level that is near to a center of the ADC input range so that a maximum input signal swing can be sampled. If the ADC input range is larger than the microphone output range, this can be addressed by adjusting the supply voltage for the microphone. For multibit feedback sigma delta ADCs, the input DC level may be selected to be between two DAC LSB (least significant bit) transitions for optimum noise performance. This can be achieved using a combination of a resistor ladder and an external capacitor. A problem with this is the area taken up by these components, particularly if the external input coupling capacitor is required to be integrated on an audio codec IC, together with additional noise generated due to the resistor ladder and capacitor acting together as a high pass filter.

### Summary

According to a first aspect there is provided a microphone input coupling circuit comprising: a sigma-delta ADC for receiving a microphone signal having a DC offset voltage and an output for providing a digital output signal, the ADC comprising a loop filter, a sampler and a feedback DAC, the loop filter having a first input for receiving the microphone signal and a second input connected to receive a feedback signal from the feedback DAC, the sampler connected to receive an output signal from the loop filter and configured to sample the output signal at a sampling rate and provide the digital output signal at the ADC output, the feedback DAC connected to receive the digital output signal and provide the feedback signal to the loop filter; and a DC control loop connected to receive the digital output signal from the ADC output and configured to provide a DC correction signal to the feedback DAC, the DC control loop comprising a low pass filter configured to extract a DC offset from the digital output signal to generate the DC correction signal, wherein the feedback DAC is configured to apply a DC offset to the feedback signal according to the DC correction signal.

The DC control loop may comprise a subtraction module configured to apply a preset correction to an output of the first low pass filter. The preset correction may be half of a least significant bit of the digital output signal.

The DC control loop may comprise a modulus operator configured to adjust an output of the first low pass filter to within a predetermined range if the digital output signal is outside of the predetermined range.

The DC control loop may comprise a second low pass filter configured to filter an output of the modulus operator.

The DC control loop may comprise a gain correction module configured to apply a gain to adjust a resolution of the digital output signal.

The DC control loop may comprise an addition module configured to apply a preset number of bits to an output of the gain correction module.

The DC control loop may comprise a loop gain module between the gain correction module and the addition module.

The DC control loop may comprise a noise shaper module configured to filter noise from the output of the first low pass filter and provide a filtered correction signal to the feedback DAC. The noise shaper module may comprise a digital loop filter and digital multi-bit quantizer configured to output the DC correction signal. The digital loop filter may be a second order loop filter, the noise shaper module comprising first and second feedback loops between an output of the noise shaper module and inputs to respective first and second components of the digital loop filter. The first and second feedback loops may have respective first and second feedback coefficients.

The feedback DAC may comprise a switchable resistor network connected to receive the ADC digital output signal and provide the feedback signal to the loop filter. The feedback DAC may comprise a variable resistor in series with the switchable resistor network, the variable resistor connected to receive the DC correction signal from the DC control loop.

The microphone input circuit may further comprise a microphone having an output connected directly to the first input of the loop filter.

These and other aspects of the invention will be apparent from, and elucidated with reference to, the embodiments described hereinafter.

### Brief description of Drawings

Embodiments will be described, by way of example only, with reference to the drawings, in which:
Figure 1 is a schematic diagram of an example conventional microphone input circuit;
Figure 2 is a schematic diagram of an example sigma-delta ADC for the circuit of Figure 1;
Figure 3 is a schematic plot of an example voltage input and DAC output for the example ADC of Figure 2;
Figure 4 is a schematic plot illustrating an example DAC output and common mode voltage;
Figure 5 is a schematic diagram of an example microphone input circuit incorporating a DC offset feedback loop;
Figure 6 is a schematic diagram of an example feedback DAC for the circuit of Figure 5;
Figure 7 is a schematic diagram of a specific example implementation of the microphone input circuit of Figure 5;
Figure 8 is a schematic diagram of an example implementation of the noise shaper module of the microphone input circuit of Figure 7;
Figure 9 is a schematic diagram illustrating a common mode input scale at different stages through the DC offset feedback loop of Figure 7;
Figure 10 is an example Bode plot of the DC offset feedback module of Figure 7;
Figures 11a and 11b illustrate example plots of a) analog input, b) first filter output, c) DC modulus output, d) second filter output and e) noise shaper output of the DC feedback loop of Figure 7 showing startup behaviour with a small input;
Figure 12 is an example plot of an output power spectrum of the microphone input circuit of Figure 7;
Figures 13a and 13b illustrate example plots of a) analog input, b) first filter output, c) DC modulus output, d) second filter output and e) noise shaper output of the DC feedback loop of Figure 7 showing behaviour with a slowly varying DC offset in the analog input;
Figure 14 is a further example plot of an output power spectrum of the microphone input circuit of Figure 7; and
Figure 15 is an example plot of an output power spectrum in dBSPL, showing an audible threshold above the output power spectrum.

It should be noted that the Figures are diagrammatic and not drawn to scale. Relative dimensions and proportions of parts of these Figures have been shown exaggerated or reduced in size, for the sake of clarity and convenience in the drawings. The same reference signs are generally used to refer to corresponding or similar feature in modified and different embodiments.

### Detailed description of embodiments

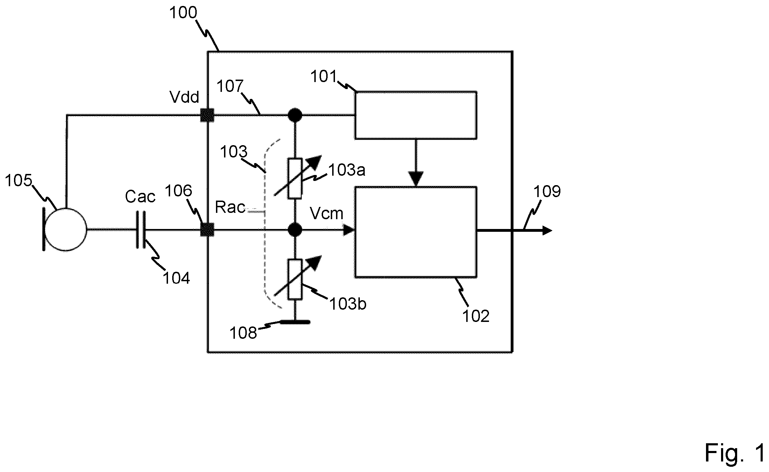

Figure 1 illustrates an example microphone input coupling circuit 100 having an input 106 connected to a microphone 105 via an AC coupling capacitor Cac 104. The input coupling circuit 100 comprises a microphone biasing circuit 101 that provides a biasing voltage Vdd to the microphone 105 and an ADC 102, which receives an input signal having a common mode voltage Vcm determined by a resistor ladder 103 having a resistance Rac divided by first and second variable resistors 103a, 103b connected between the supply voltage line 107 and ground 108. The ADC 102 outputs a digital signal 109 that can be processed by other components on an audio codec chip that includes the input coupling circuit 100.

The resistance Rac of the resistor ladder 103 and capacitance Cac of the coupling capacitor 104 act together as a high pass filter. The balance of the first and second variable resistors 103a, 103b making up the resistance Rac defines the input DC voltage Vcm. The input DC voltage Vcm should ideally be at the middle of the input range of the ADC 102 to avoid clipping. Clipping can be avoided by adjusting the voltage Vdd provided by the biasing circuit 101 so that the input range of the ADC 102 is larger than the output range of the microphone 105. A second purpose of the coupling capacitor 104 and resistor ladder 103 is to tune an offset to be at a desired point for optimum noise performance. For a multibit sigma-delta ADC, the offset should be in the middle of two DAC LSB transitions for optimum noise performance.

The input coupling circuit 100 of Figure 1 has three main drawbacks. Firstly, an external capacitor is required. Secondly, additional area is taken up by the resistor ladder 103. Thirdly, additional noise is created due to the capacitor and resistor ladder acting as a high pass filter. The noise *uₙ* from the high pass filter can be calculated as: ${υ}_{n} = \sqrt{\frac{2 kT}{πC} \left[arctan\left(2{πf}_{high}{R}_{ac}{C}_{ac}\right)-arctan\left(2{πf}_{low}{R}_{ac}{C}_{ac}\right)\right]}$ where *f_{high}* and *f_{low}* are the upper and lower frequencies of the band of interest. This noise contribution becomes more significant in the case of a smaller capacitor value Cac, which is driven by the desire to integrate this coupling capacitor on-chip.

Commonly used topologies for microphone ADCs include multibit continuous time sigma-delta ADCs, which may be used in audio applications in place of a pre-amplifier to avoid audible artefacts such as glitches or noise pumping that can often arise in systems using signal-dependent automatic gain switching.

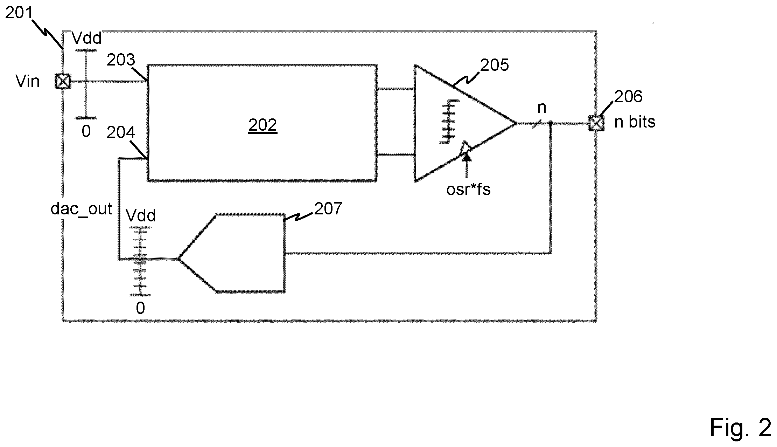

Figure 2 illustrates an example multibit sigma-delta ADC 201 that may be used as the ADC 102 of Figure 1. The ADC 201 comprises a loop filter 202 that receives an input signal Vin at a first input 203 and a feedback signal dac_out at a second input 204. The loop filter 202 provides an output signal to a sampler 205 that is provided with a sampling signal having a sampling rate osr*fs, where osr is an oversampling ratio and fs a sampling frequency. The sampler 205 outputs an n-bit digital output signal at an output 206 of the ADC 201. The digital output signal is fed back via an n-bit feedback DAC 207, which provides the feedback signal dac_out to the second input 204 of the loop filter 202.

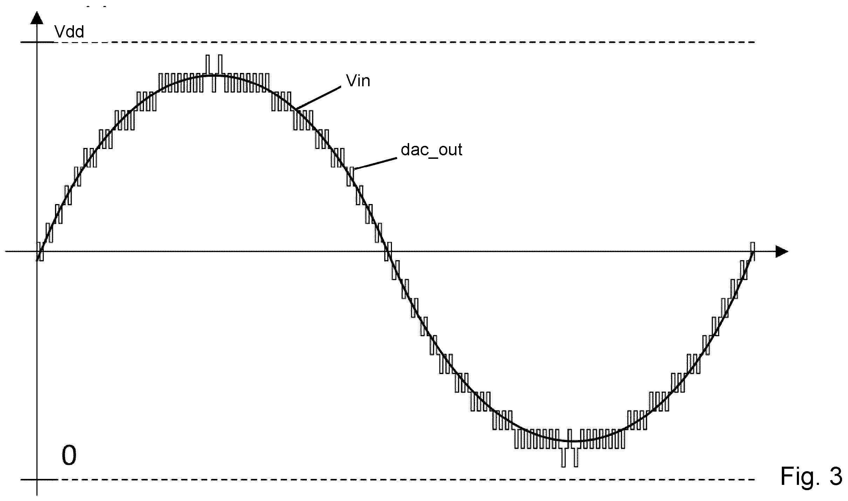

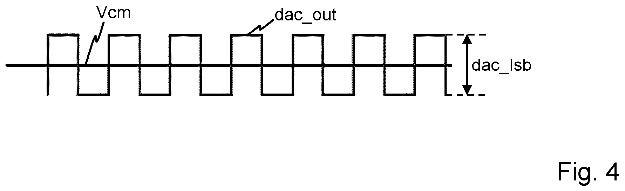

Figure 3 is an example plot of a microphone input signal Vin and the corresponding DAC output dac_out that is fed back to the loop filter 202. The number of bits in the DAC 207 plays an important role in the amount of distortion. As mentioned above, the resistor ladder 103 (Figure 1) tunes the DC input common mode voltage Vcm such that it lies between two DAC LSBs, as shown schematically in Figure 4, which provides the optimum noise performance.

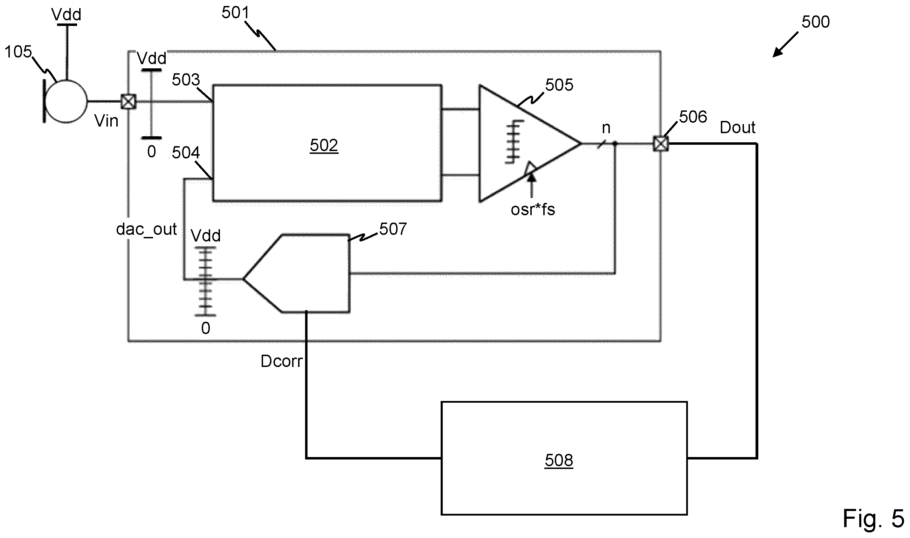

Figure 5 illustrates an example microphone input coupling circuit 500 comprising a sigma-delta ADC 501 and a digital DC control loop 508. In place of an external capacitor and AC coupling ladder, the microphone input coupling circuit 500 uses the digital DC control loop 508 to tune a DC level for the ADC input. A microphone 105 may therefore be connected directly to the ADC input, i.e. with no intervening AC coupling capacitor.

Similarly to the sigma-delta ADC 201 of Figure 2, the sigma-delta ADC 501 comprises a loop filter 502 that receives an input signal Vin at a first input 503 and a feedback signal dac_out at a second input 504. The loop filter 502 provides an output signal to a sampler 505, which is provided with a sampling signal having a sampling rate osr*fs, where osr is an oversampling ratio and fs a sampling frequency. The sampler 505 samples the output signal from the loop filter 502 and provides an n-bit digital output signal Dout at an output 506 of the ADC 501. The digital output signal Dout is fed back to the loop filter 502 via a feedback DAC 507, which provides the feedback signal dac_out to the second input 504 of the loop filter 502.

The digital DC control loop 508 also receives the digital output signal Dout from the ADC output 506 and provides a DC correction signal Dcorr to the feedback DAC 507. The DC correction Dcorr is applied by the DAC 507 to adjust a DC offset of the feedback signal dac_out. The effect of this is to remove any DC offset from the input signal Vin, thereby eliminating the need for an external capacitor connected between the first input 503 and the microphone 105. The DC control loop 508 comprises a digital low pass filter that is configured to extract a DC offset from the digital output signal Dout and generate the DC correction signal Dcorr.

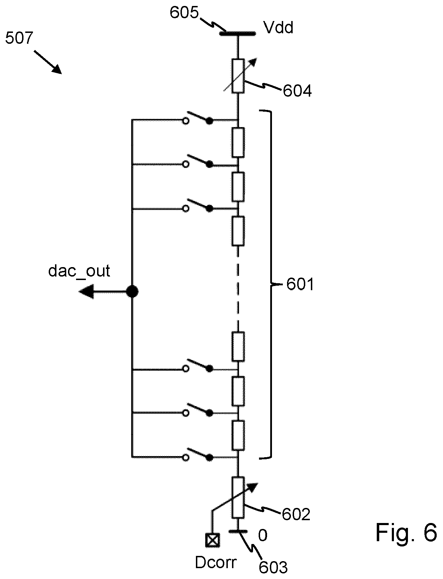

Figure 6 illustrates an example implementation of the feedback DAC 507 of the ADC 501, which comprises a switchable resistor network 601 having an array of switches and resistors, the switches being connected to receive the ADC digital output signal Dout to provide the feedback signal dac_out to the loop filter 502. A variable resistor 602, which may also be implemented with an array of resistors and switches, is connected in series with the resistor network 601 and is connected to receive the digital DC correction signal Dcorr. In this example, the variable resistor 602 is connected between a ground connection 603 and the resistor network 601. A further variable resistor 604 may be connected between a supply voltage connection 605 and the resistor network 601, which may also be connected to the DC correction signal. With a single variable resistor, the DC offset of the feedback DAC 507 can be adjusted, but the input range of the ADC is affected at the same time. Using two variable resistors as shown in Figure 6, both of which are connected to the DC correction signal, the DC offset can be adjusted while keeping the input range of the ADC constant.

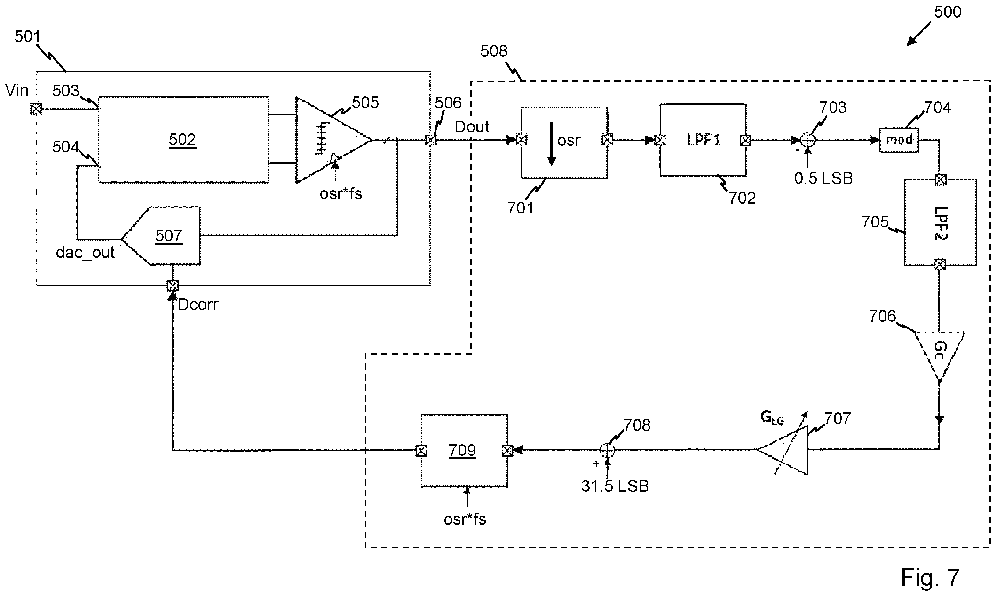

Figure 7 illustrates an example implementation of the microphone input coupling circuit 500 of Figure 5 in which other components of the DC control loop 508 are provided to perform various functions. The sigma-delta ADC 501 is described above, comprising the loop filter 502, sampler 505 and feedback DAC 507. The DC control loop 508 comprises a first low pass filter 702 that is configured to extract the DC offset from the digital output signal Dout to generate the DC correction signal Dcorr. Other components in the module perform various functions to process the digital output signal Dout and to adjust the output from the first low pass filter 702 to provide the DC correction signal Dcorr to the feedback DAC 507.

If the sampler 505 oversamples the output signal from the loop filter 502, a downsampling module 701 connected between the ADC output 506 and the first low pass filter 702 downsamples the digital output signal. The downsampling module may downsample the digital output signal by the same amount as the oversampling ratio of the sampler 505 or may downsample the digital output signal by a higher or lower sampling rate. The downsampling module 701 provides a downsampled signal to the first low pass filter 702. In a particular example, the oversampling ratio osr may be 128 and the digital output signal may be a 6-bit signal. A transfer function of the first low pass filter may be expressed as $\frac{1}{z - {a}_{1}}$.

An output of the first low pass filter 702 may be provided to a subtraction module 703 to apply a preset correction, which in this example involves subtracting 0.5 LSB (least significant bit) from the output of the first low pass filter 702. The output of the subtraction module 703 is provided to a modulus operator 704, which operates to fold back an out-of-range signal. A second low pass filter 705, with a transfer function of $\frac{1}{z - {a}_{2}}$, operates to smooth out any sharp modulus transitions resulting from the modulus operator 704. The modulus operator 704 and second low pass filter 705 are optional and may not be required if the signal is not expected to be out of range.

A signal from the second low pass filter 705 may be provided to a gain correction module 706, which applies a preset gain to change the scale from that of the ADC output to a scale suitable for the DC correction signal. A loop gain module 707 may be provided to adjust the loop gain. An addition module 708 then adds a predetermined number of bits to the signal before the signal is provided to a noise shaper module 709.

The purpose of the noise shaper module 709 is to ensure that any signal from the DC control loop 508 is below an audible level. To achieve this, a dynamic range (DR) of the noise shaper module should be larger than the DR of the sigma delta ADC 501. If the DR of the output of the noise shaper module 709 is sufficiently high, is does not contribute to the noise floor of the sigma delta ADC 501. The order of the noise shaper module 709 may be less than the order of the loop filter 502 of the ADC 501 so that the noise shaper module 709 can filter out a noise shaped spectrum from the DC control loop 508.

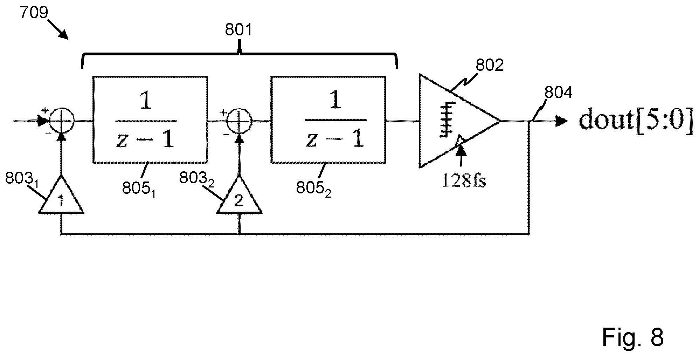

An example arrangement for the noise shaper module 709 is illustrated in Figure 8. In this example, the noise shaper module 709 comprises a digital second order loop filter 801 in combination with a digital multi-bit quantizer 802. First and second feedback loops connect an output 804 of the noise shaper module 709 to inputs of respective first and second components 805₁, 805₂ of the loop filter 801 via respective first and second feedback coefficients 803₁, 803₂.

The resolution of the DC control loop 508, which may for example be 6 bits, may be mapped to 1.0 LSB of the ADC. The resolution at the input of the noise shaper module 709 may be the same as or different to the resolution of the main Sigma Delta ADC 501, which in the examples provided is also 6 bits. These resolutions are however not interlinked and can be chosen independently.

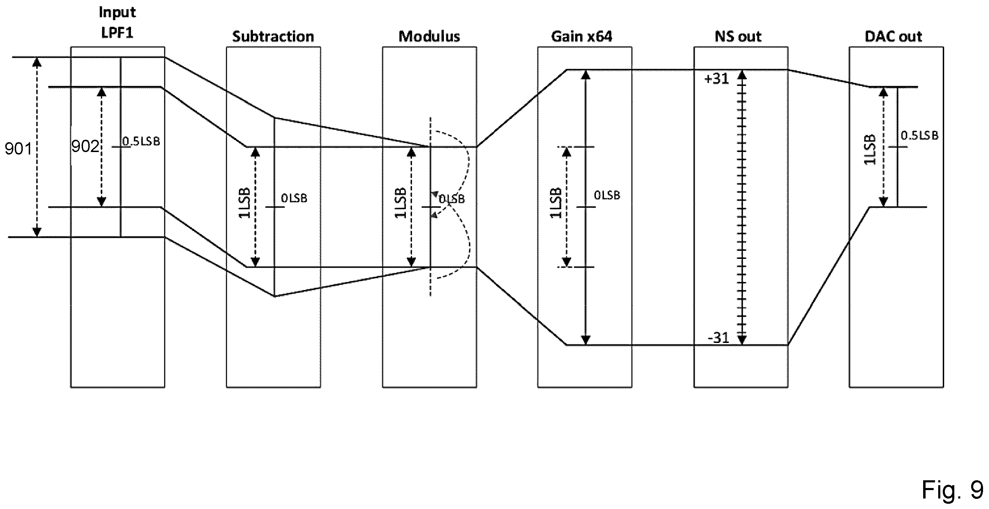

Figure 9 illustrates how a scale of the common mode voltage may vary at different stages in the DC control loop 508. At the input to the first low pass filter module 702, the common mode voltage may have a range 901 that is out of a correction range of the loop or may have a range 902 that is within a correction range of the loop, i.e. a range of 1 LSB. The subtraction module 703 then subtracts a present amount, in this case 0.5 LSB. The modulus operator 704 then brings any out-of-range voltage to within the range of 1 LSB. The gain correction module 706 then applies a preset gain, in this example a gain of 64 times before the noise shaper module 709 filters out noise from the signal. The output of the DC control loop 508 is applied to the feedback DAC 507, which outputs the feedback signal dac_out within a range of 1 LSB.

Table 1 below provides two examples of how the common mode level may be adjusted throughout the various stages of the DC control loop 508 of the type described herein. In a first example, a default input of 0 LSB to the ADC 501 results in a 0.5 LSB input to the first low pass filter 702, which is adjusted back to 0 LSB by the subtraction module 703 by subtracting 0.5 LSB. The gain correction module 706 does not alter this. The addition module 708 adds 31.5 LSB, resulting in 31.5 LSB input to the noise shaper module 709, which then provides a 31 or 32 LSB output to the feedback DAC 507. In a second example, an input with a 0.1 LSB offset is provided to the ADC 501, which results in a 0.6 LSB being provided to the first low pass filter 702. The subtraction module 703 corrects this to 0.1 LSB and the gain correction module 706 increases this to 6 LSB. The addition module 708 then adds 31.5 LSB and the noise shaper module 709 outputs a 38 or 39 LSB output to the feedback DAC 507.

**Table 1 - Example common mode levels throughout the DC control loop.**

| | Vin | LPF1 Input | Subtraction Output | Gain Output | Addition Output | Noise Shaper Output |
|---|---|---|---|---|---|---|
| Default Input | 0 | 0.5 | 0 | 0 | 31.5 | 31/32 |
| 0.1 LSB Offset | 0.1 | 0.6 | 0.1 | 6 | 37.5 | 38/39 |

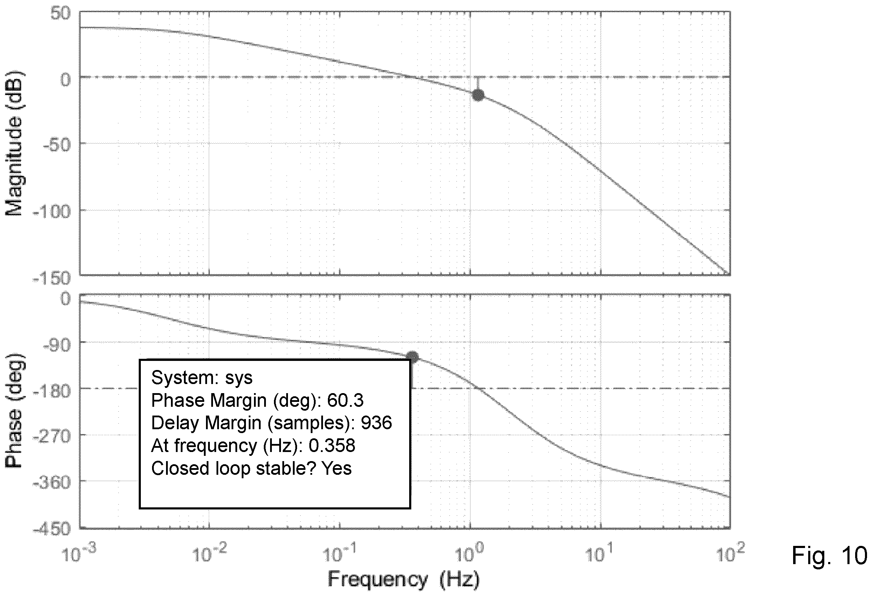

The example DC control loop 508 described herein is a second order loop with no stability zero. No stability zero is required because the second pole is placed well above the unity gain frequency of the loop. The main purpose of the second LPF 705 is to filter out sharp transition from the modulus operator 704. An example bode plot of the DC control loop 508 is illustrated in Figure 10, which shows a phase margin of around 60 degrees. Other low pass filter configurations may also be used, with the general aim that the DC control loop should provide a smooth DC control behaviour and proper loop stability.

The desired DC output of the ADC 501 is 0.5LSB, i.e. between two DAC codes. Subtracting 0.5LSB after the first low pass filter 702 removes the DC and then the loop converges to a solution which make the output of the subtractor module 703 zero.

The correction range used in the example DC control loop is 1.0 DAC LSB in total. If this range is exceeded, the modulus operator 704 avoids clipping and adjusts the signal to the centre of noise shaper code.

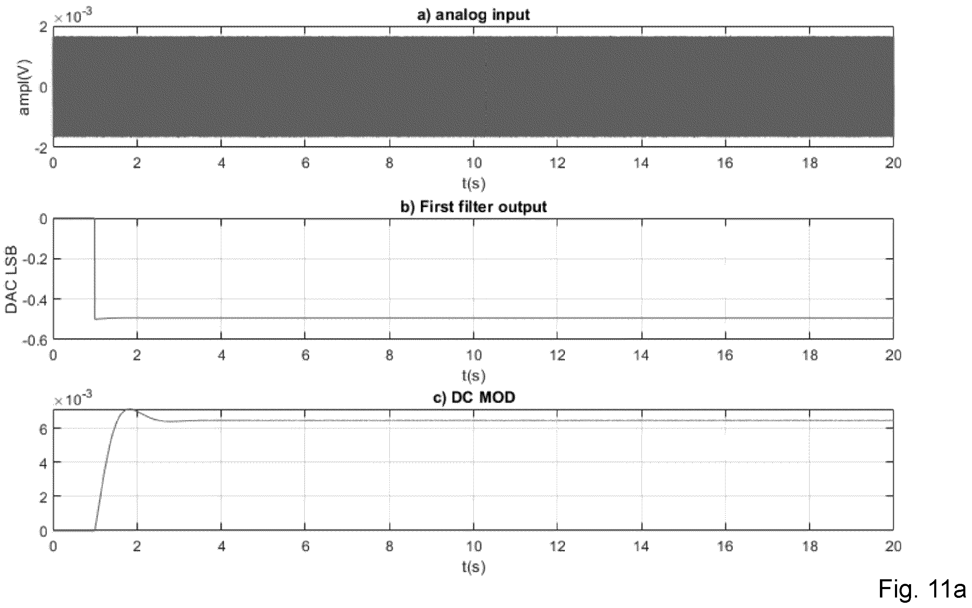

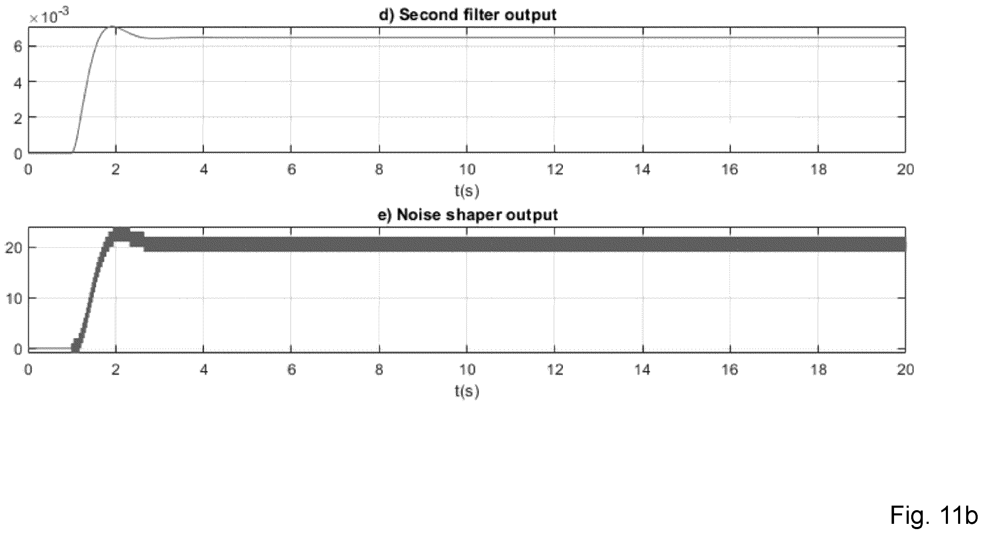

To speed up convergence of the DC control loop 508 at system startup, before the DC control loop is activated an average value at the output of the ADC 501 may be calculated and the first LPF 702 may be initialized with that loop. This principle is similar to coupling capacitor initialization where the loop is allowed to settle before the channel is unmuted. Figures 11a and 11b illustrate how the filter and noise shaper outputs settle after a short time, in this example within around 1 to 2 seconds.

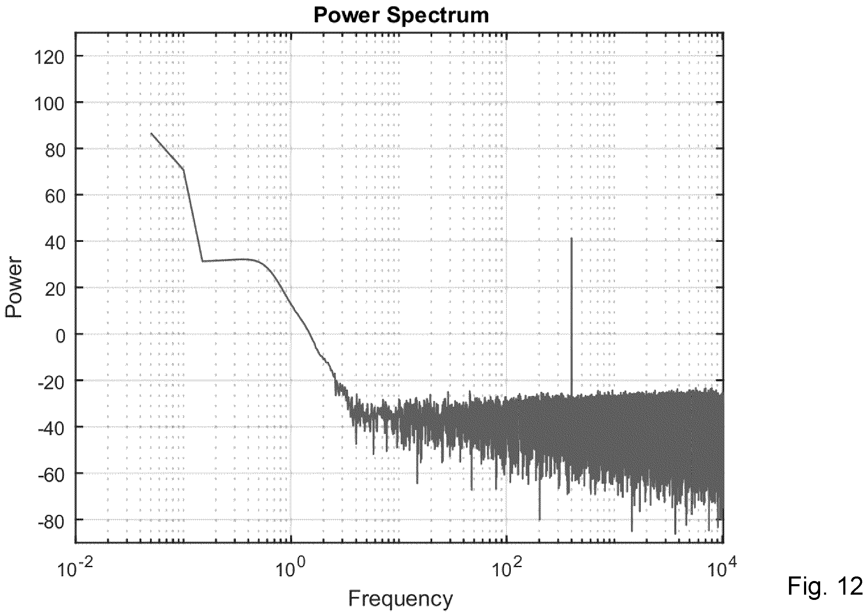

Figure 12 illustrates an example output power spectrum of the microphone input coupling circuit 500 with a 400 Hz -80dB FS input.

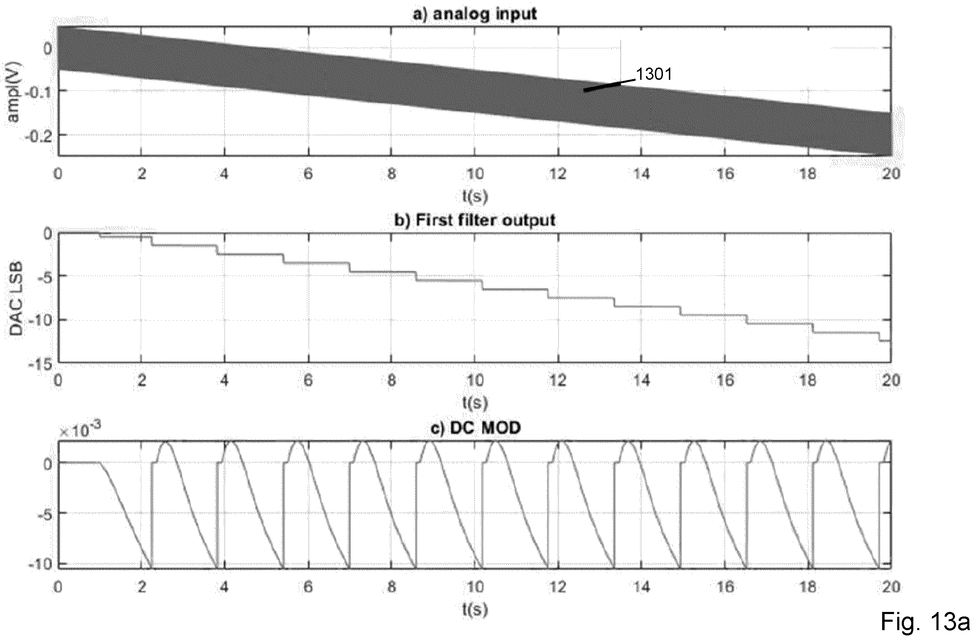

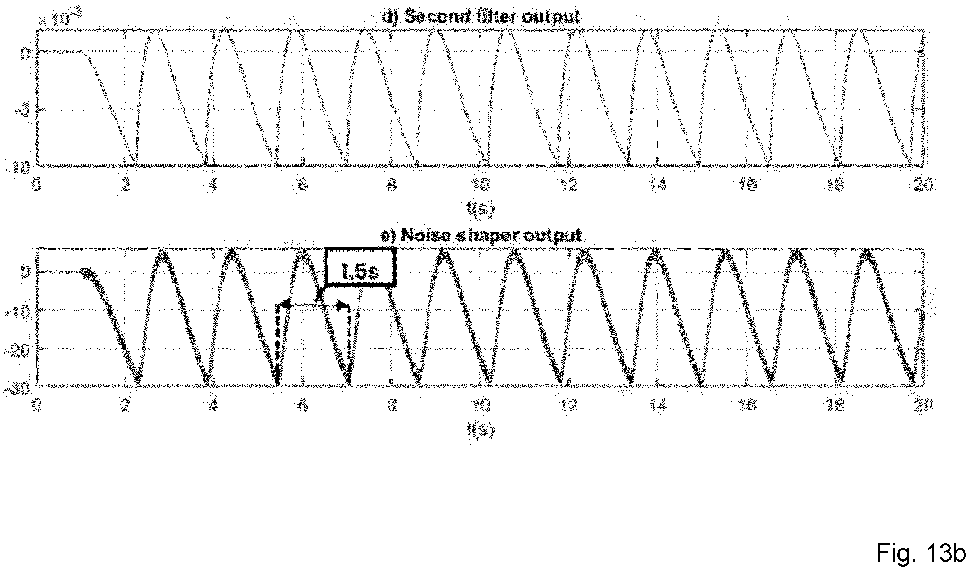

Figures 13a and 13b illustrate the behaviour of the response of the DC control loop 508 to a slowly varying DC offset, which is applied to the analog input 1301. This results in a series of step changes to the output of the first low pass filter and a series of corrections provided by the modulus operator as the DC level changes. The second low pass filter smooths out these changes and the noise shaper output provides a varying output signal to the feedback DAC 507. The oscillation frequency of the noise shaper output is in this example well below the audible range.

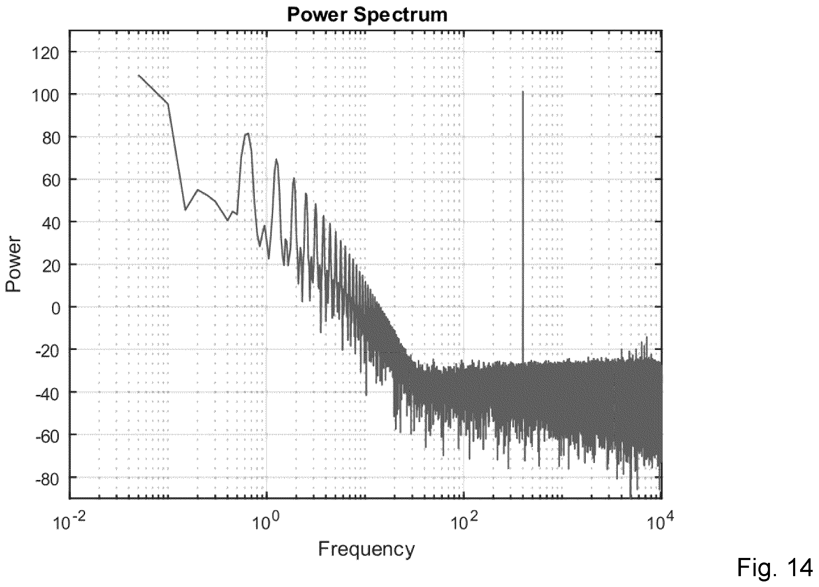

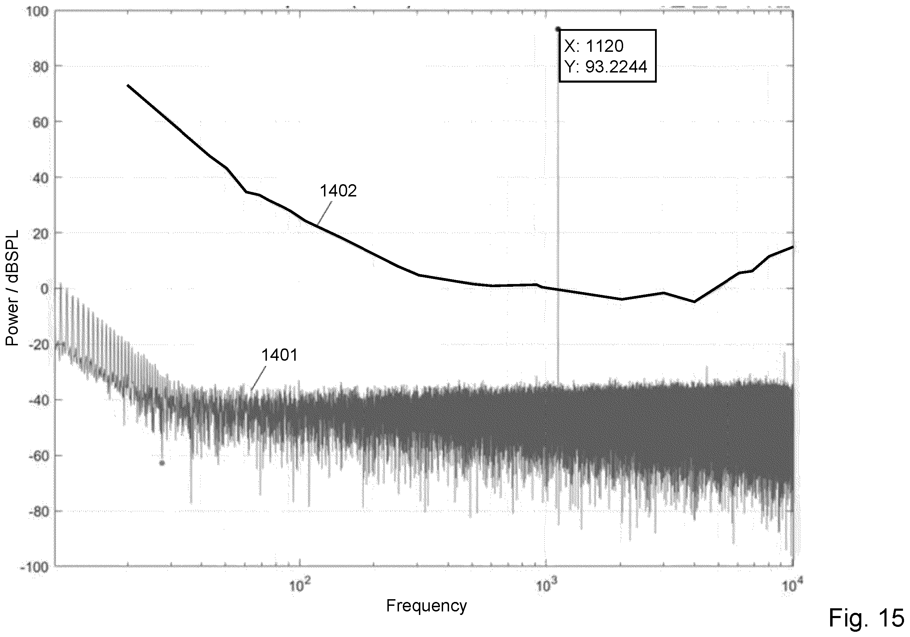

Figure 14 illustrates a power spectrum 1401 of an ADC output translated to dBSPL for a typical example microphone (Knowles SPA2629LR5H). This power spectrum is compared in Figure 15 with a Fletcher-Munson audibility threshold curve 1402. This shows that the output spectrum of ADC is well below the audible threshold.

In summary, the microphone input circuit described herein allows for elimination of an input AC-coupling capacitor and resistor ladder. As result, a significant reduction in overall area occupied together with a low noise level is achieved.

From reading the present disclosure, other variations and modifications will be apparent to the skilled person. Such variations and modifications may involve equivalent and other features which are already known in the art of microphone input circuits, and which may be used instead of, or in addition to, features already described herein.

Although the appended claims are directed to particular combinations of features, it should be understood that the scope of the disclosure of the present invention also includes any novel feature or any novel combination of features disclosed herein either explicitly or implicitly or any generalisation thereof, whether or not it relates to the same invention as presently claimed in any claim and whether or not it mitigates any or all of the same technical problems as does the present invention.

Features which are described in the context of separate embodiments may also be provided in combination in a single embodiment. Conversely, various features which are, for brevity, described in the context of a single embodiment, may also be provided separately or in any suitable sub-combination. The applicant hereby gives notice that new claims may be formulated to such features and/or combinations of such features during the prosecution of the present application or of any further application derived therefrom.

For the sake of completeness it is also stated that the term "comprising" does not exclude other elements or steps, the term "a" or "an" does not exclude a plurality, a single processor or other unit may fulfil the functions of several means recited in the claims and reference signs in the claims shall not be construed as limiting the scope of the claims.

## Claims

1. A microphone input coupling circuit (500) comprising:
a sigma-delta ADC (501) for receiving a microphone signal having a DC offset voltage and an output (506) for providing a digital output signal, the ADC (501) comprising a loop filter (502), a sampler (505) and a feedback DAC (507), the loop filter (502) having a first input (503) for receiving the microphone signal and a second input (504) connected to receive a feedback signal (dac_out) from the feedback DAC (507), the sampler (505) connected to receive an output signal from the loop filter (502) and configured to sample the output signal at a sampling rate and provide the digital output signal at the ADC output (506), the feedback DAC (507) connected to receive the digital output signal and provide the feedback signal (dac_out) to the loop filter (502); and
a DC control loop (508) connected to receive the digital output signal from the ADC output (506) and configured to provide a DC correction signal (Dcorr) to the feedback DAC (507), the DC control loop (508) comprising a low pass filter (702) configured to extract a DC offset from the digital output signal to generate the DC correction signal (Dcorr),
wherein the feedback DAC (507) is configured to apply a DC offset to the feedback signal (dac_out) according to the DC correction signal (Dcorr).

2. The microphone input coupling circuit (500) of claim 1, wherein the DC control loop (508) comprises a subtraction module (703) configured to apply a preset correction to an output of the first low pass filter (702).

3. The microphone input coupling circuit (500) of claim 2, wherein the preset correction is half of a least significant bit of the digital output signal.

4. The microphone input coupling circuit (500) of any of claims 1 to 3, wherein the DC control loop (508) comprises a modulus operator (704) configured to adjust an output of the first low pass filter (702) to within a predetermined range if the digital output signal is outside of the predetermined range.

5. The microphone input coupling circuit (500) of claim 4, wherein the DC control loop (508) comprises a second low pass filter (705) configured to filter an output of the modulus operator (704).

6. The microphone input coupling circuit (500) of any preceding claim, wherein the DC control loop (508) comprises a gain correction module (706) configured to apply a gain to adjust a resolution of the digital output signal.

7. The microphone input coupling circuit (500) of claim 6, wherein the DC control loop (508) comprises an addition module (708) configured to apply a preset number of bits to an output of the gain correction module (706).

8. The microphone input coupling circuit (500) of claim 7, wherein the DC control loop (508) comprises a loop gain module (707) between the gain correction module (706) and the addition module (708).

9. The microphone input coupling circuit (500) of any preceding claim, wherein the DC control loop (508) comprises a noise shaper module configured to filter noise from the output of the first low pass filter (702) and provide a filtered correction signal (Dcorr) to the feedback DAC (507).

10. The microphone input coupling circuit (500) of claim 9, wherein the noise shaper module (709) comprises a digital loop filter (801) and a digital multi-bit quantizer (802) configured to output the DC correction signal (Dcorr).

11. The microphone input coupling circuit (500) of claim 10, wherein the digital loop filter (801) is a second order loop filter, the noise shaper module (709) comprising first and second feedback loops between an output (804) of the noise shaper module (709) and inputs to respective first and second components (805₁, 805₂) of the digital loop filter (801).

12. The microphone input coupling circuit (500) of claim 11, wherein the first and second feedback loops have respective first and second feedback coefficients (803₁, 803₂).

13. The microphone input coupling circuit (500) of any preceding claim, wherein the feedback DAC (507) comprises a switchable resistor network (601) connected to receive the ADC digital output signal and provide the feedback signal (dac_out) to the loop filter (502).

14. The microphone input coupling circuit (500) of claim 13, wherein the feedback DAC (507) comprises a variable resistor (602) in series with the switchable resistor network (601), the variable resistor (602) connected to receive the DC correction signal (Dcorr) from the DC control loop (508).

15. The microphone input coupling circuit (500) of any preceding claim, comprising a microphone (105) having an output connected directly to the first input (503) of the loop filter (502).
